# EUROPEAN PATENT APPLICATION

(11) **EP 1 365 516 A1**
(43) Date of publication of application: **26.11.2003**
(21) Application number: 02715777.5
(22) Date of filing: 17.01.2002
(51) Int. Cl.: H03M 7/30

(54) **COMPRESSION METHOD AND DEVICE, DECOMPRESSION METHOD AND DEVICE, COMPRESSION/DECOMPRESSION SYSTEM, RECORDING MEDIUM**

(30) Priority: 19.01.2001 JP 2001010892
(71) Applicant: Sakai, Yasue, Urawa-shi, Saitama 336-0932 (JP)
(72) Inventor: KOYANAGI, Yukio, Saitama-shi, Saitama 336-0932 (JP)
(74) Representative: VOSSIUS & PARTNER
(86) International application number: JP0200277
(87) International publication number: WO02058244

(57) **Abstract**

Data to be compressed is differentiated for respective sampling points (S1-S20) and their absolute values are sequentially added to obtain differential total data (D1-D20). Then sampling points, where when data between two sampling points is subject to linear interpolation, an error between the interpolated data and the original data is up to a desired value, that is, points where even when data at each sampling point is reproduced only by decompression processing using linear interpolation, an error between the reproduced data and the original data is insignificant, are detected as sample points, and average differential value data between discrete sample points, timing data indicating time intervals between sample points, and polarity data of differential values at respective sampling points only are obtained as compression data, thereby improving the quality of data reproduced by decompressing with high compression ratio maintained.

## Description

### [Background of the Invention]

### [Field of the Invention]

The present invention relates to a compression method and device, a decompression method and device, a compression/decompression system and a recording medium and, in particular, to a compression and decompression system of continuous analog signals or digital signals.

### [Description of the Related Art]

Conventionally, in case of transmitting or accumulating a signal with a large amount of information such as an image signal or a voice signal, the signal is compressed and decompressed for the purpose of reducing an amount of transmitted information and extending savable time in an accumulating medium. In general, in case of compressing an analog signal, first, the analog signal is sampled in accordance with a predetermined sampling frequency to be digitized, and obtained digital data is subjected to compression processing.

For example, in compression of an image signal or a voice signal, a method of performing compression in a frequency area after processing original data using a conversion filter of time axis - frequency axis such as DCT (Discrete-Cosine-Transform). DPCM (Differential Pulse Code Modulation) often used in a telephone line as a compression system of a voice signal is also used aiming at this point. Further, this compression system by DPCM is a system for coding a differential of neighboring sample values when a waveform is sampled.

In addition, as a system for performing time/frequency conversion, there is also a system using a sub-band filter or MDCT (Modified Discrete Cosine Transform). There is an MPEG (Moving Picture Image Coding Experts Group) audio as a coding system using such a system.

In addition, a compression system of an image most widely used is generally known as this MPEG standard as well.

Decompression processing of data compressed in accordance with the above-described compression system is basically performed by an opposite operation of the compression processing of the same compression system.

That is, compressed digital data is subjected to predetermined decompression processing after being converted from a signal of a frequency area to a signal of a time area by means of frequency-to-time conversion, whereby original digital data is reproduced. Then, the original data found in this way is digital-analog converted according to necessity and outputted as an analog signal.

In general, in considering compression and decompression of data, it is an important subject to find how to improve a quality of reproduced data while increasing a compression ratio. However, in the above-described conventional compression/decompression system, there is a problem in that, when it is attempted to increase a compression ratio of an image signal or a voice signal, a quality of an image or a voice that is reproduced by decompressing compression data is deteriorated and, conversely, when importance is attached to a quality of a reproduced image or a reproduced voice, a compression ratio of an image signal or a voice signal decreases. Thus, it is extremely difficult to realize both improvement of a compression ratio and improvement of a quality of reproduced data.

In addition, in the above-described conventional compression/decompression system, since a signal on a time axis is converted to a signal on a frequency axis to be compressed, processing such as time/frequency conversion in compression and frequency/time conversion in decompression becomes necessary. Thus, there is a problem in that processing becomes complicated and, at the same time, a structure for realizing this becomes extremely complicated. This is a factor for extending a processing time required for compression and decompression and making miniaturization of an apparatus difficult.

The present invention has been devised in order to solve such problems, and it is an object of the present invention to provide a completely new compression/decompression system that realizes both improvement of a compression ratio and improvement of a quality of reproduced data.

### [Summary of the Invention]

In order to solve the above-described subject, in a compression side of the present invention, for example, data to be compressed is differentiated for respective sampling points and their absolute values are sequentially added to obtain differential total data for the respective sampling points. Then, processing is performed such that sampling points where, when data between two sampling points is subject to linear interpolation with respect to the differential total data in each sampling point obtained by the above calculation, an error between the interpolated data and the original data is up to a desired value are sequentially detected as sample points of compression data.

In addition, on a decompression side, for example, amplitude data at respective sampling points is found based on differential total data at respective sample points included in compression data, timing data representing a time interval between the sample points and polarity data of a differential value in each sampling point. Then, an interpolation calculation for interpolating amplitude data in the found each sampling point is performed, whereby decompression data is obtained.

In another aspect of the present invention, on a compression side, processing is performed such that sampling points where all errors between each data value on a straight line connecting data of two sampling points and each differential total data value in the same sampling points as each data value on the straight line are up to a desired value, which are sampling points where a time interval between the two sampling points is the longest within a predetermined range, are subsequently detected as sample points of compression data.

In another aspect of the present invention, on a compression side, processing is performed such that sampling points where an error between a data value on a straight line connecting data of two sampling points and a differential total data value in the same sampling point as the data value on the straight line is up to a desired value, which are sampling points immediately before sampling points where the error exceeds the desired, are subsequently detected as sample points of compression data.

In another aspect of the present invention, compression data includes differential total data at each sample point, timing data representing a time interval between sample points and polarity data of a differential value in each sampling point.

In another aspect of the present invention, compression data includes timing data representing a time interval between each sample point, data of an average differential value per a unit time between sample points and polarity data of a differential value in each sampling point.

In another aspect of the present invention, on a compression side, regular sample data in a few points in each sampling point is adopted as a part of compression data. This regular sample data is used in performing interpolation processing on a decompression side.

In addition, it is possible to arbitrarily detect a regular data point, for example, it is possible to detect a regular data point for each sampling point of a fixed interval or an unfixed interval.

In addition, in a course of finding differential total data for each sampling point, in a sampling point where a value of differential total data exceeds a predetermined threshold value or a sampling point where a difference between data value of a sampling point in which regular sample data is adopted last time and a value of differential total data found for each sampling point exceeds a predetermined threshold value, regular sample data may be adopted as a part of compression data.

In addition, in a course of finding differential total data for each sampling point, in a sampling point where, when data between two sampling points is subject to linear interpolation, an error between the interpolated data and the original data exceeds a desired value, regular sample data may be adopted as a part of compression data.

Further, in another aspect of the present invention, sampling points where, when data between two sampling points included in data to be compressed is subject linear interpolation, an error between the interpolated data and the original data is up to a desired value, are subsequently detected as sample points, a set of amplitude data of each sample point and timing data representing a time interval between each sample point is obtained as linear compression data and, at the same time, amplitude data of each sample point included in the linear compression data and timing data between each sample point are used to find interpolation data for linearly interpolating amplitude data having a time interval indicted by the timing data, whereby decompression data is obtained. Processing according to any one of first to seventeenth aspects of the present invention is applied to this decompression data.

Since the present invention consists of the above-described technical means, sampling points where, even when data at each sampling point is reproduced from average differential value data between samples points and polarity data of a differential value in decompression processing, an error between the reproduced data and the original data is not larger than a desired value, are detected as sample points, and only differential total data at discrete sample points detected in this way, average differential value data per a unit time between the sample points, timing data representing a time interval between the sample points, polarity data of a differential value of each sampling point, and the like are generated as compression data, whereby it becomes possible to remarkably improve a quality of data reproduced by decompression while realizing a high compression ratio.

In addition, according to the present invention, instead of performing error judgment as described above with respect to sample data itself in each sampling point to compress data, processing of error judgment with respect to differential total data generated by differentiating each sample data and sequentially adding their absolute values, whereby it becomes possible to reduce the number of sample points to be detected as much as possible and it becomes possible to realize a higher compression ratio even if a signal with a high frequency, that is, a signal whose sample data value changes relatively largely even in sampling points proximate to each other is compressed.

Moreover, according to the present invention, it becomes possible to perform processing on a time axis directly without performing time/frequency conversion to perform processing on a frequency axis in compressing a signal on the time axis. In addition, it becomes possible to perform processing on a time axis directly in decompressing data compressed in this way. In particular, on a decompression side, it becomes possible to reproduce highly precise decompression data that is almost the same as the original data before compression simply by performing extremely simple processing such as processing for multiplying an average differential value by polarity to sequentially add products or interpolation processing (which may be simple processing such as linear interpolation).

In addition, according to another characteristic of the present invention, on a compression side, sampling points where all errors between each data value on a straight line connecting data of two sampling points and each differential total data value in the same sampling point as each data value on the straight line are up to a desired value, which are sampling points where a time interval between the two sampling points is the longest within a predetermined range, are sequentially detected as sample points of compression data, whereby respective values of timing data can be controlled to be within predetermined bits and it becomes possible to improve a compression ratio so much for that.

In addition, according to another characteristic of the present invention, on a compression side, sampling points where an error between a data value on a straight line connecting data of two sampling points and a differential total data value in the same sampling point as the data value on the straight line is up to a desired value, which are sampling points immediately before sampling points where the error exceeds the desired value, are sequentially detected as sample points of compression data, whereby it becomes possible to make an interval between sample points as long as possible to reduce the number of sample points to be detected as much as possible and it becomes possible to realize a high compression ratio.

In addition, according to another characteristic of the present invention, average differential value data per a unit time between sample points is included as compression data, whereby it becomes possible to reduce respective data amounts and it becomes possible to further increase a compression ratio compared with the case in which differential total data itself at each sample point is included as compression data. In addition, since it is unnecessary to perform processing for calculating average differential value data from differential total data and timing data at each sample point on a decompression side, it becomes possible to reduce load of processing.

In addition, according to another characteristic of the present invention, on a compression side, regular sample data in a few points in each sampling point is adopted as a part of compression data, whereby it becomes possible to eliminate an accumulated error, which may be generated by reproducing data of each sampling point using average differential value data between sample points found from differential total data, by the regular sample data inserted into some places and it becomes possible to improve reproducibility of a signal to be reproduced from compression data by decompression.

In this case, in a course of finding differential total data for each sampling point, regular sample data is adopted as a part of compression data in sampling points where a value of the differential total data exceeds a predetermined threshold value, whereby it becomes possible to control a value of the differential total data included as a part of the compression data not to be larger than a threshold value and it becomes possible to reduce respective data amount and increase a compression ratio.

In addition, the regular sample data is adopted as a part of compression data in sampling points where, when two differential total data are subject to linear interpolation, an error between the interpolated data and the original data exceeds a desired value, whereby it becomes possible to insert the regular sample data for each part where the accumulation error may be generated to eliminate generation of an accumulated error and it becomes possible to further improve reproducibility of a signal to be reproduced from compression data by decompression.

Further, according to another characteristic of the present invention, on a compression side, data compression is performed to find differential total data as described above after applying linear compression/decompression processing to sample data itself, whereby it becomes possible to perform the data compression after removing an unnecessary high frequency component to be a cause of noise in advance. Consequently, it becomes possible to further improve a compression ratio and, at the same time, it becomes possible to further improve a quality of data to be reproduced by decompression based on the compression data.

### [Brief Description of the Drawings]

FIG. 1 is a graph for explaining a basic principle of a compression system according to a first embodiment;
FIGS. 2A and 2B are graphs for explaining the basic principle of the compression system according to the first embodiment;
FIG. 3 is a graph for explaining a basic principle of a decompression system according to the first embodiment;
FIG. 4 is a block diagram showing an example of a functional configuration of a compression device according to the first embodiment;
FIG. 5 is a block diagram showing an example of a functional configuration of a decompression device according to the first embodiment;
FIG. 6 is a graph for explaining a basic principle of a compression system according to a second embodiment;
FIG. 7 is a graph for explaining a basic principle of a decompression system according to the second embodiment;
FIG. 8 is a block diagram showing an example of a functional configuration of a compression device according to the second embodiment;
FIG. 9 is a block diagram showing an example of a functional configuration of a compression device according to a third embodiment;
FIG. 10 is a graph showing waveforms of an original analog signal (input data) before compression and a reproduced analog signal (output data) obtained by compressing and decompressing the analog signal;
FIG. 11 is a graph showing a partly enlarged waveforms of those shown in FIG. 10; and
FIG. 12 is a characteristic graph showing correlation between an original analog signal (input data) before compression and a reproduced analog signal (output data) obtained by compressing and decompressing the analog signal.

### [Detailed Description of the Preferred Embodiments]

### (First embodiment)

A first embodiment of the present invention will be hereinafter described based on the drawings.

In a compression system of this embodiment, first, in case of inputting an analog signal as a signal to be compressed, the inputted analog signal is A/D converted to digital data. Then, the following compression processing is applied to the obtained digital data. In addition, in case of inputting digital data as a signal to be compressed, the following compression processing is directly applied to the digital data.

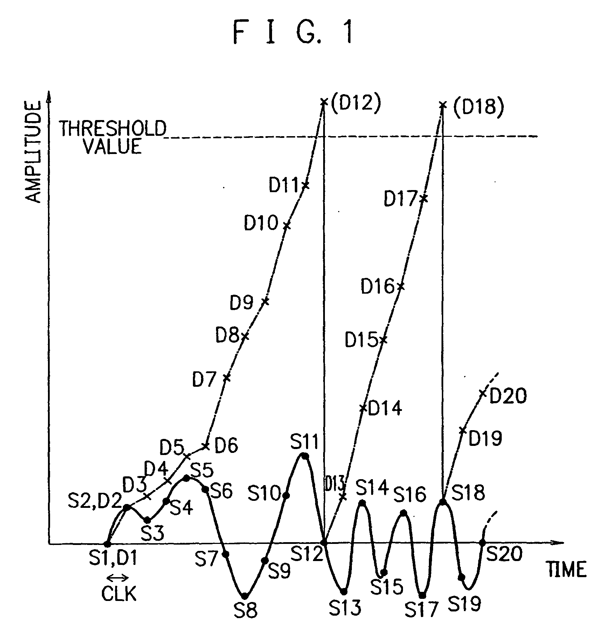

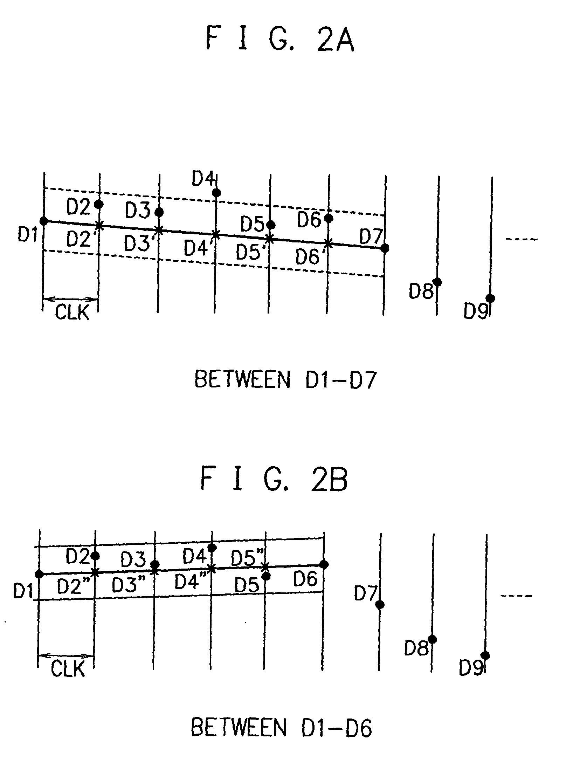

FIG. 1 and FIGS. 2A and 2B are graphs for explaining a basic principle of compression processing according to the first embodiment. In FIG. 1, the horizontal axis represents time and the vertical axis represents amplitudes of data. A wave form of a solid line shown in FIG. 1 shows an example of an analog signal to be compressed. In addition, reference symbols S1 to S20 denote a part of digital data that is obtained by sampling an analog signal to be compressed for each clock CLK based on a predetermined sampling frequency. In the example of FIG. 1, the sample data S1 is data of a reference sample point that is adopted first.

In this embodiment, digital data (sample data S1 to S20) to be compressed is differentiated for respective sampling points, and their respective sampling values are sequentially added. Reference symbols D1 to D20 in FIG. 1 denote data values obtained by sequentially adding a differential absolute value of each sampling point (hereinafter referred to as differential total data). That is, the differential total data D2 at a second sampling point is a value found by adding the differential absolute value D2 between the sample data S1 and S2 to a differential absolute value (D1=0) at a first sampling point.

In addition, the differential total data D3 at a third sampling point is a value found by adding a differential absolute value between the sample data S2 and S3 to the immediately preceding differential total data D2. Moreover, the differential total data D4 at a fourth sampling point is a value found by adding a differential absolute value between the ample data S3 and S4 to the immediately preceding differential total data D3. Thereafter, a differential absolute value of each sampling point is sequentially added in the same manner, whereby the differential total data D1 to D20 is found for each sampling point.

Then, in the course of adding a differential absolute value of each sampling point, if a differential total data exceeds a predetermined threshold value, a regular sample data is adopted instead of differential total data for a sampling point at which the differential total data value exceeds the threshold value (this sampling point is hereinafter referred to as a regular data point). In the example of FIG. 1, since the differential total data D12 exceeds the threshold value at a twelfth sampling point, regular sample data S12 is adopted in this sampling point.

Thereafter, a differential absolute value of each sampling point is sequentially added with this regular sample data S12 as a starting point. Then, since the differential total data value D18 exceeds the threshold value again at an eighteenth sampling point, the regular sample data S18 is also adopted in this sampling point. Then, the same processing is repeated thereafter with this sample data S18 as a starting point.

Moreover, processing of linear compression described below is applied to the differential total data D1 to D20 in each sampling point obtained in this way. That is, sampling points where an error between a data value on a straight line connecting between data of two sampling points (between differential total data or between regular sample data and differential total data) and a differential total data value at the same sampling point as the data value on the straight line is up to a desired value are sequentially detected as sample points. Then, discrete differential total data at detected each sample point and timing data (the number of clocks) representing a time interval between and each sample point or between a sample point and a regular data point is found, and these are transmitted or recorded as a part of compression data.

The processing for detecting sample points will be described as follows more specifically. That is, data to be a reference and the other data whose time interval from there is within a predetermined range are selected out of differential total data in each sampling point or regular sample data in each regular data point. Then, sampling points where all errors between each data value on a straight line connecting between the two data and each differential total data value in the same sampling point as each data value on the straight line is up to a desired value, which are sampling points whose time interval is the longest within the predetermined range, are detected as sample points.

FIGS. 2A and 2B are graphs for explaining this operation principle. In FIGS. 2A and 2B, the horizontal axis represents time and the vertical axis represents amplitudes of differential total data or the like. D1 to D9 shown in FIGS. 2A and 2B are a part of the differential total data found by the processing of FIG. 1. Not that, although values of the differential total data D1 to D9 shown in FIGS. 2A and 2B do not agree with those in FIG. 1 strictly for convenience of explanation, the following processing is actually executed with respect to the data values shown in FIG. 1.

In addition, a time interval between two data that are selected in detecting a discrete sample point is set within six clocks at the maximum. Further, if three bits or four bits are used as a timing data value, it is possible to set a time interval between differential total data to seven clocks or fifteen clocks at the maximum.

First, as shown in FIG. 2A, the reference differential total data D1 and the differential total data D7 whose time interval from there is the maximum within a predetermined range are selected. Then, it is judged whether all of respective errors between data values D', D3', D4', D5' andD6' on a straight line connecting between the two differential total data and each differential total data value D2, D3, D4, D5 and D6 in the same sampling point as each data value D2' to D6' on the straight line are up to a desired value.

That is, all errors between the data values D2', D3', D4', D5' and D6' on the straight line connecting between the two differential total data D1 and D7 and each differential total data value D2, D3, D4, D5 and D6 corresponding to these values are within a range of desired values shown by a dot line. If this condition is met, the sampling point of the differential total data D7 is detected as a sample point. However, in this example, since an error between the data value D4' on the straight line and the differential total data value D4 corresponding to it exceeds the desired value, the sampling point of the differential total data D7 is not adopted as a sample point at this point in time and the processing is put forward.

Next, as shown in FIG. 2B, the differential total data D6 whose time interval from the reference differential total data D1 is one clock CLK shorter than the differential total data D7 is selected. Then, it is judged whether or not all of respective errors between a data value D2'', D3'', D4'' and D5'' of each sampling point on a straight line connecting between the two differential total data D1 and D6 and each differential total data value D2, D3, D4 and D5 in the same sampling point as each data value D2'' to D5'' on the straight line are up to a desired value.

Here, if all the errors are up to the desired value, a sampling point of the differential total data D6 is detected as a sample point. In this example, since all the errors between each data value D2'', D3'', D4'' and D5'' on the straight line and each differential total data value D2, D3, D4 and D5 are up to the desired value, this sampling point of the differential total data D6 is detected as a sample point.

Further, if any of the conditions of errors that all the errors are up to the desired value with respect to the respective straight lines connected between D1 and D7, between D1 and D6, ..., and between D1 and D3 is not met, a sampling point of the differential total data D2 is detected as a sample point. That is, since other differential total data does not exist between the sample data D1 and D2, it is unnecessary to perform the above-described error calculation for this section. Thus, if any of the conditions of errors is not met with respect to the respective straight lines connected in other sections, a position of the differential total data D2 next to the differential total data D1 that is currently used as a reference is detected as a sample point.

When one sample point is detected, the sample point is used as a reference differential total data anew to perform the same processing as above within a range of six clocks from there. In the present example, a sampling point where all errors are up to a desired value within the range of six clocks from the differential total data D6 and a time interval from the differential total data D6 is the longest is detected as the next sample point.

Thereafter, a plurality of sample points are sequentially detected in the same manner. In doing so, selection of two data forming a straight line is performed with an interval from a certain regular data point to the next regular data point as one segment. In this case, sample data of the regular data point (in the case of FIG. 1, S12 and S18) is necessarily used as data on a reference side.

Then, a set of an amplitude value of differential total data at each discrete sample point detected in this way and a timing data value representing a time interval between each sample point or between a regular data point and a sample point by the number of clocks CLK is obtained as a part of compression data. In the above-described example, sets (D1, 5), (D6, *) ... of differential total data values (D1, D6, ...) in each sample point and timing data values (5, *, ...) are obtained as a part of compression data (* indicates undecided in this example). In addition, sample data S12 and S18 of a regular data point also form a part of the compression data.

Further, although the example in which sampling points where a time interval between two data is the maximum within a predetermined range (differential total data D1 and D7 in the example of FIG. 2) are selected first to start error judgment and processing is put forward in the direction of sequentially reducing the time interval is described here, a direction of sample point search is not limited to this.

For example, sampling points where a time interval between two differential total data is the minimum within a predetermined range (differential total data D1 and D3 in the example of FIG. 2) may be selected first to start error judgment and processing may be put forward in the direction of sequentially extending the time interval. In addition, sampling points where a time interval between two differential total data is around a center within a predetermined range (e.g., differential total data D1 and D4 in the example of FIG. 2) may be selected to start error judgment.

The above-described linear compression processing shown in FIG. 2 will be described in accordance with the example of FIG. 1. First, the processing as shown in FIG. 2 is performed in a segment from the first differential total data D1 (= sample data S1) to the eleventh differential total data D11 corresponding to a sampling point immediately before a first regular data point. Consequently, one or more sample points are detected and differential total data values in the sample points, and timing data values representing a time interval between the sample points are obtained.

Next, the processing as shown in FIG. 2 is performed in a segment from the twelfth sample data S12 that is the first regular data point to the seventeenth differential total data D17 corresponding to a sampling point immediately before a second regular data point. Consequently, one or more sample points are detected in this segment as well, and differential total data values in the sample points and timing data values representing a time interval between the sample points are obtained. Moreover, the same processing is executed for the eighteenth sample data value S18 that is the second regular data point and the subsequent sample data values.

Then, differential total data at each sample point detected in each segment in this way, timing data representing a time interval between the sample points or between a regular data point and a sample point, regular sample data in each regular data and data representing polarity of differential data at each sampling point are obtained as compression data, which are transmitted to a transmission medium or recorded in a recording medium.

In this way, according to the compression system of this embodiment, since only differential total data in discrete sample points extracted out of each sampling point in data to be compressed, timing data representing a time interval between sample points, sample data of discrete regular points, polarity data of each differential value that can be simply represented by either "0" or "1" are obtained as compression data, a high compression ratio can be realized.

Moreover, if two or more sampling points satisfying conditions of an error concerning certain one reference data are detected within a predetermined range, sampling points where a time interval from the reference data is the longest are detected as sample points. In this way, a value of timing data can be controlled to be in predetermined bits and, at the same time, the number of sample points to be detected can be reduced as much as possible and a high compression ratio can be realized.

In addition, according to the compression system of this embodiment, since the processing of the linear compression is applied to the differential total data D1 to D20 that are generated by differentiating each sample data S1 to S20 to sequentially add their absolute values instead of applying the processing of the linear compression as shown in FIG. 2 to each sample data S1 to S20 itself, a compression ratio can be further increased compared with the case in which the processing of the linear compression is applied to each sample data S1 to S20 due to the following reasons.

That is, if the linear compression is applied to each sample data S1 to S20 itself, most of the sampling points are detected as sample points in a part where a frequency is high as in the twelfth sample data S12 and the subsequent sample data (data in which a sample data value changes relatively largely even at sampling points proximate to each other). Thus, it is necessary to have amplitude data with a relatively large information amount for each sampling point as compression data.

On the other hand, if the linear interpolation is applied to the differential total data D1 to D20, sample points can be taken discretely even in a part where a frequency is high as in the twelfth sample data S12 and the subsequent sample data and the number of sample points to be detected can be reduced as much as possible. Therefore, the number of differential total data in sample points that should be held as compression data can be reduced as much as possible, and a compression ratio can be increased.

Next, the decompression system of this embodiment for decompressing the compression data generated as described above will be described. On a decompression side, an amplitude data value of a sampling point that can exist between the discrete sample points detected on the compression side is found based on differential total data at each sample point included in inputted compression data, timing data representing a time interval between sample points, or the like, and polarity data of each differential value.

More specifically, average differential value data per a unit time is found from a difference of data values in two sampling points and timing data and a value found by multiplying the found average differential value data by polarity data of a differential value at each sampling point is sequentially added to an immediately preceding amplitude data value, whereby an amplitude data value at each sampling point is found.

Then, an interpolation calculation for interpolating the above-described found amplitude data at each sampling point and regular sample data included in the compression data is sequentially performed, whereby interpolation data for interpolating respective data is generated. Moreover, the generated interpolation data is D/A converted to an analog signal and outputted according to necessity.

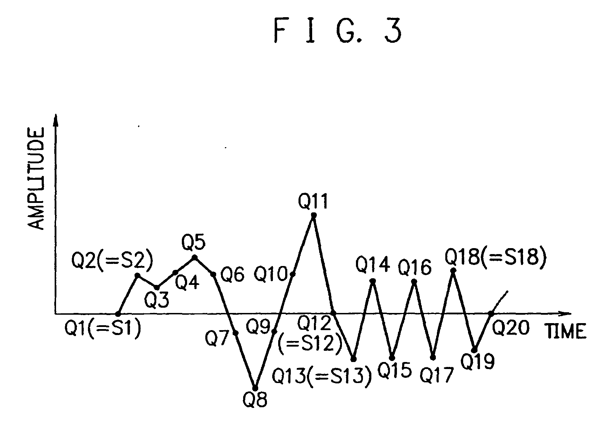

FIG. 3 is a graph for explaining this decompression principle. In FIG. 3, reference symbols Q1 to Q20 denote amplitude data values at each decompressed sampling point. Among them, Q1, Q12 and Q18 are regular sample data in a regular data point. In addition, it is assumed here that five points of the differential total data D2, D6, D11, D13 and D17 are detected as sample points as a result of the processing shown in FIG. 1.

In this case, since other sampling points do not exist between the first regular sample data S1 included in the compression data and the differential total data D2 at the first sample point, the regular sample data S1 and the differential total data D2 are directly adopted as the amplitude data values Q1 and Q2 of decompression data.

In addition, since four sampling points exist between the differential total data D2 at the first sample point and the differential total data D6 at the next sample point, the amplitude data values Q3 to Q6 at these four sampling points are found based on the differential total data D2 and D6 at two sample points included in the compression data, timing data (4CLK) between the sample points and polarity data (-, +, +, -) of a differential value at each sampling point.

That is, an average differential data value per one clock (= (D6 - D2)/4) is calculated from a difference of the differential total data values D2 and D6 in two sample points and a timing data value (4CLK) between the sample points. Then, a value found by multiplying this average differential data value by polarity data (-, +, +, -) of a differential value at each sampling point is sequentially added to the immediately preceding amplitude data Q2, whereby the amplitude data values Q3 to Q6 at four sampling points are found.

Moreover, since five sampling points exist between the differential total data D6 at the second sample point and the differential total data D11 at the third sample point, the amplitude data values Q7 to Q11 at these five sampling points are found based on the differential total data D6 and D11 at two sample points, timing data (5CLK) between the sample points and polarity data (-, -, +, +, +) of a differential value at each sampling point.

That is, first, an average differential data value per one clock (= (D11 - D6)/5) is calculated from a difference of the differential total data values D6 and D11 at two sample points and the timing data value (5CLK) between the sample points. Then, a value found by multiplying this average differential data value by polarity data (-, -, +, +, +) of a differential value at each sampling point is sequentially added to the immediately preceding amplitude data value Q6, whereby the amplitude data values Q7 to Q11 at the five sampling points are found.

Next, the second regular sample data S12 included in the compression data is directly adopted as the amplitude data value Q12 of the decompression data. Thereafter, the same processing as described above is performed, whereby the amplitude data values Q13 to Q20 are found at each sampling point. Then, interpolation data of a waveform as shown in FIG. 3 is obtained by interpolating (e.g., linear interpolation) the amplitude data values Q1 to Q20 at each sampling point found as described above. Moreover, the D/A conversion processing is applied to the generated interpolation data to convert it into an analog signal and output it.

In this way, in the decompression system of this embodiment, average differential value data per one clock is found from differential total data at each sample point, which is included in compression data generated in accordance with the compression system of this embodiment, and timing data, and the amplitude data values Q1 to Q20 at each sampling point are found from the average differential value data and polarity data of a differential value at each sampling point.

At the time of compression of this embodiment, if the linear interpolation is applied between two differential total data (or between regular sample data and differential total data), it is examined how much error other differential total data between the two differential total data has from the interpolated straight line to detect a point where an error is not increased even if the linear interpolation is performed is detected as a sample point. Therefore, even if average differential value data is calculated from differential total data of discrete each sample point obtained in this way to find amplitude data between sample points, data of a waveform substantially the same as the original data before compression can be reproduced.

However, although an error amount from the original data is naturally reduced if respective segments to which error judgment is applied on the compression side are viewed microscopically, it is possible that the slight error accumulates as a plurality of segments are processed and the error from the original data gradually increases if the entire segments are viewed macroscopically. However, in this embodiment, since regular sample data at a few points in each sampling point is adopted as a part of the compression data, the accumulated errors can be eliminated by regular sample data inserted in several places, and reproducibility of a signal reproduced by decompression from the compression data to the original data can be improved.

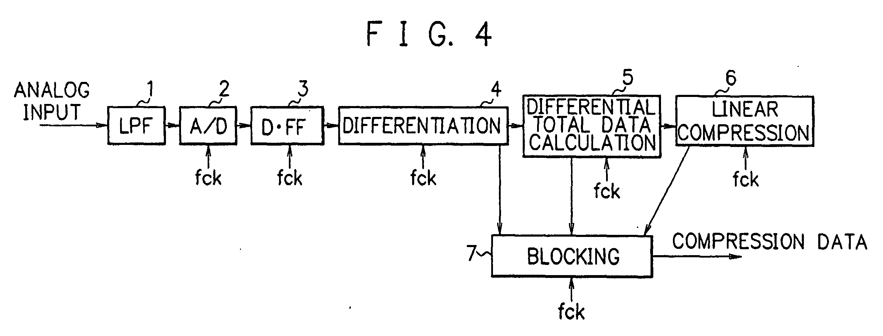

FIG. 4 is a block diagram showing an example of a functional configuration of a compression device according to the first embodiment that realizes the above-described compression system. The compression device shown in FIG. 4 is applicable to, for example, a case in which an analog voice signal is inputted and compressed. Note that, if a digital voice signal is inputted, a low pass filter (LPF) 1 in a first stage and an A/D conversion unit 2 are unnecessary.

As shown in FIG. 4, the compression device of this embodiment is constituted by an LPF 1, an A/D conversion unit 2, a D type flip flop 3, a differentiation unit 4, a differential total data calculation unit 5, a linear compression unit 6 and a blocking unit 7.

The LPF 1 is for removing noise of a high frequency component by applying filtering processing to an analog signal inputted as an object of compression in order to facilitate detection of a sample point.

The A/D conversion unit 2 converts an analog signal outputted from the LPF 1 into digital data. In doing so, the A/D conversion unit 2 executes A/D conversion processing in accordance with an input clock of a predetermined frequency fck (e.g., in the case of a voice signal, 44.1 KHz) to be a reference. The D type flip flop 3 holds digital data at each sampling point outputted from the A/D conversion unit 2 in accordance with the input clock of the reference frequency fck.

The differentiation unit 4 differentiates sample data outputted from the D type flip flop 3. In doing so, the differentiation unit 4 performs differentiating of sample data every time it is given the input clock of the reference frequency fck, that is, for each sampling point based on the reference frequency fck. A differential value is found, for example, by deducting present data captured at timing of a certain input clock from data captured at timing of an immediately preceding clock in terms of time.

The differential total data calculation unit 5 finds an absolute value of the differential value calculated for each sampling point by the differentiation unit 4 and sequentially adds respective absolute values for each sampling point. In doing so, if differential total data that is their added value exceeds a predetermined threshold value, regular sample data is adopted for the sampling point where the differential total data exceeds the threshold value. According to such processing, the differential total data calculation unit 5 generates differential total data D1 to D20 of a waveform shown by an alternate long and short dash line of FIG. 1.

The linear compression unit 6 applies processing of linear compression as described in FIG. 2 to the differential total data D1 to D20 generated by the differential total data calculation unit 5. Consequently, the linear compression unit 6 detects discrete sample points out of each sampling point based on the reference frequency fck and finds an amplitude data value of differential total data at each sample point and a timing data value representing a time interval between each sample point, or the like.

The blocking unit 7 appropriately blocks data representing polarity of a differential value at each sampling point calculated by the differentiation unit 4, sample data of a regular data point found by the differential total data calculation unit 5, differential total data at each sample point found by the linear compression unit 6 and timing data representing a time interval between each sample point, or the like, and outputs the blocked data as compression data. The outputted compression data is, for example, transmitted to a transmission medium or recorded in a recording medium such as a nonvolatile memory.

Further, in this blocking, if polarity data of differential values at each sampling point represented by two values of "0" and "1" is divided into separate fields for each segment of a sample point to be blocked, a time interval (the number of clocks) between sample points can be represented by the number of polarity data included in one field. Therefore, in this case, it is possible to make timing data unnecessary as compression data.

Next, a decompression device corresponding to the compression device described above will be described.

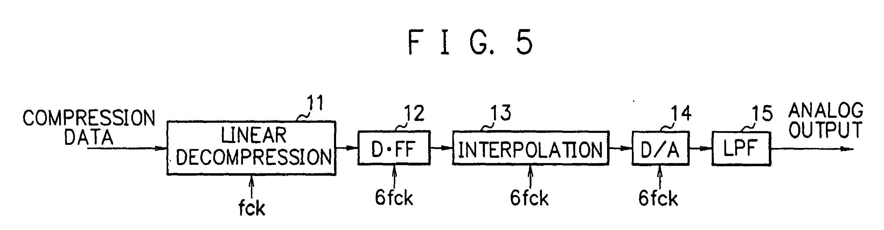

FIG. 5 is a block diagram showing an example of a functional configuration of the decompression device according to this embodiment. As shown in FIG. 5, the decompression device of this embodiment is constituted by a linear decompression unit 11, a D type flip flop 12, an interpolation processing unit 13, a D/A conversion unit 14 and an LPF 15.

The linear decompression unit 11 applies processing of linear decompression as described in FIG. 3 to compression data to be inputted, thereby realizing the amplitude data Q1 to Q20 for each sampling point based on the reference frequency fck. The D type flip flop 12 holds the amplitude data Q1 to Q20 at each sampling point outputted from the linear decompression unit 11 in accordance with a clock of a six times frequency 6fck. Consequently, the digital data Q1 to Q20 at each sampling point is over sampled by six times.

The interpolation processing unit 13 performs calculation for interpolating the amplitude data Q1 to Q20 at each sampling point of the reference frequency fck, for example, by a straight line using data over sampled by the D type flip flop 12 and generates interpolation data of a waveform as shown in FIG. 3. The D/A conversion unit 14 D/A converts the interpolation data generated in this way into analog signal. The LPF 15 applies filtering processing to the analog signal converted by the D/A conversion unit 14, thereby removing noise of a high frequency component and outputting the analog signal as a reproduced analog signal.

According to the structure as described above, average differential value data per one clock between sample points is found from differential total data at each sample point, and amplitude data at each sampling point is further found from the average differential value data. Then, interpolation data for interpolating the amplitude data is outputted as decompression data. As it is seen from this, on a decompression side, highly precise decompression data can be reproduced almost the same as the original data before compression can be reproduced simply by performing extremely simple processing such as linear decompression processing and linear interpolation processing.

The compression device and the decompression device according to this embodiment constituted as described above is constituted by, for example, a computer system provided with a CPU or an MPU, a ROM, a RAM and the like, and all or a part of their functions (e.g., the differentiation unit 4, the differential total data calculation unit 5, the linear compression unit 6 and the blocking unit 7 of the compression device, the linear decompression unit 11 and the interpolation processing unit 13 of the decompression device, and the like) are realized by a program stored in the above-described ROM or RAM operating.

In addition, the compression device and the decompression device according to this embodiment constituted as described above can be constituted in a hardware-like manner by combining a logic circuit. Note that a hardware configuration for realizing the function of the linear compression unit 6 of the compression device and the function of the linear decompression unit 11 of the decompression device is described in detail in Japanese Patent Application No. 2000-168625 submitted by the applicant of this application before. The configuration described in detail in Japanese Patent Application No. 2000-168625 can be applied to this embodiment.

As described above in detail, in this embodiment, sampling points where, even when amplitude data of each sampling point is reproduced from average differential value data and polarity data of a differential value in the decompression processing, an error between the reproduced data and the original data is not larger than a desired value are sequentially detected as sample points. Then, only differential total data at discrete sample points detected in this way, timing data representing a time interval between the sample points, or the like, sample data of discrete regular data points and polarity data of a differential value at each sampling point are obtained as compression data. Consequently, a quality of data reproduced by decompression can be improved while realizing a high compression ratio.

In particular, according to the compression/decompression system of this embodiment, interpolation data generated by linear interpolation not only has a small error of its amplitude compared with the original data before compression but also can control phase difference to be very small. Although phase difference affects a tone significantly if a voice is used as data to be compressed, since this phase difference hardly occurs in this embodiment, a tone of the original data can be reproduced faithfully.

In addition, in this embodiment, linear compression processing is applied to differential total data that is generated by differentiating each sample data to sequentially adding their absolute values instead of applying the linear compression processing to sample data itself at each sampling point. Consequently, even if a signal of a high frequency is compressed, the number of sample points to be detected can be reduced as much as possible and a high compression ratio can be realized.

In addition, according to this embodiment, since an analog signal or digital data to be compressed can be straightly compressed or decompressed on a time axis without time/frequency converting it, processing does not become complicated and a structure can be simplified. In addition, if compression data is transmitted from a compression side and reproduced on a decompression side, since compression data to be inputted can be sequentially processed and reproduced by extremely simple linear interpolation calculation or the like on a time axis, a real time operation can be realized.

In addition, in this embodiment, if a value of differential total data exceeds a predetermined threshold value in a course of calculating differential total data for each sampling point, regular sample data is adopted as a part of compression data for the sampling point. It is needless to mention that differential values at all sampling points may be sequentially added without performing such processing to perform error judgment for each predetermined clock range with respect to the differential total data found in this way and sequentially detect sample points. However, regular sample data is adopted every time the predetermined threshold value is exceeded, whereby accumulated errors can be eliminated each time and reproducibility of an analog signal reproduced by decompression from compression data can be improved.

Further, in the above-describe first embodiment, differential total data at each sample point, timing data representing a time interval between the sample points, regular sample data at each regular data point and polarity data of a differential value at each sampling point are found as compression data, and average differential value data per one clock is found on a decompression side from the differential total data at each sample point and the timing data included in this compression data. However, this average differential value data may be found on a compression side to make it a part of compression data.

As compression data in this case, the differential total data at each sample point becomes unnecessary, and it is sufficient to have average differential value data per one clock between the sample points instead of that. Consequently, respective data amounts can be reduced compared with the case in which differential total data itself is held as compression data, and a compression ratio as awhole can be further improved. In addition, in the decompression side, calculation for finding average differential value data also becomes unnecessary, and calculation load can be reduced to shorten a reproduction time.

In addition, although regular sample data is adopted if differential total data exceeds a predetermined threshold value and, thereafter, differential total data is found with the regular sample data as a starting point in the above-described first embodiment, the present invention is not limited to this example. For example, if a difference between a data value of a sampling point at the time when regular sample data is employed last time and a value of differential total data found for each sampling point exceeds a predetermined threshold value, regular sample data may be adopted at the sampling point.

If regular sample data is adopted in this way, it becomes unnecessary to turn back a data value for each regular data point as shown in FIG. 1 in finding differential total data of each sampling point. Thus, it is possible to adopt regular sample data every time the above-described difference exceeds the threshold value while simply adding all differential absolute values of each sampling point first and applying linear compression processing for detecting sample points to differential total data found by the addition. Consequently, an algorithm on the compression side can be simplified and calculation load can be reduced.

Further, in this case, although a differential total data value at a sample point becomes larger in later stages and a compression ratio decreases, if average differential value data is used as compression data, a high compression ratio can be maintained.

In addition, although the example in which the digital data Q1 to Q20 are linearly interpolated in the interpolation processing unit 13 is described in the above-described first embodiment, an interpolation calculation is not limited to this example. For example, curve interpolation processing may be performed using a predetermined sampling function. In addition, interpolation processing described in Japanese Patent Application No. 11-173245 and the like that the applicant of this application filed before may be performed. In this case, since a waveform extremely close to analog can be obtained by interpolation itself, it is possible to make the D/A conversion unit 14 or the LPF 15 in later stages of the interpolation processing unit 13 unnecessary.

### (Second embodiment)

Next, a second embodiment of the present invention will be described.

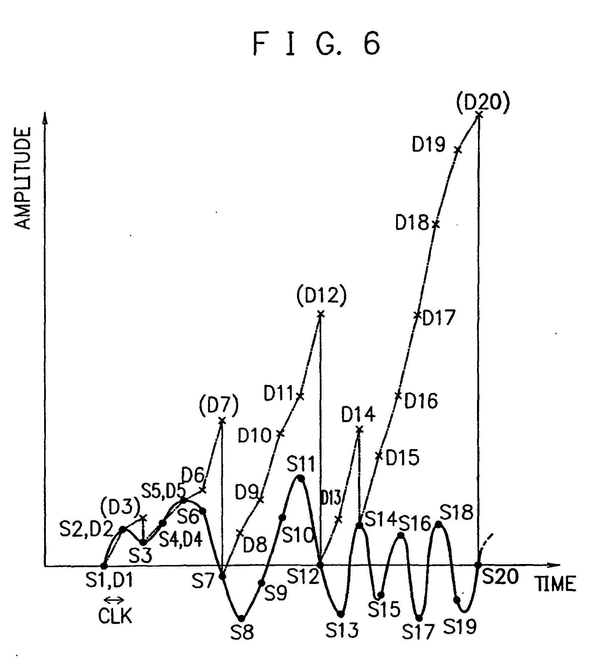

FIG. 6 is a graph for explaining a basic principle of compression processing according to the second embodiment. In FIG. 6, a waveform of a solid line indicates an example of an analog signal to be compressed, and S1 to S20 are a part of digital data that is obtained by sampling an analog signal to be compressed for each clock CLK based on a predetermined sampling frequency. This analog waveform and sample data S1 to S20 are completely the same as those shown in FIG. 1.

The second embodiment is the same as the first embodiment shown in FIG. 1 in that digital data to be compressed is differentiated for respective sampling points and their absolute values are sequentially added. A major difference between the second embodiment and the first embodiment is a way of taking regular data points. That is, in the second embodiment, the error judgment as shown in FIG. 2 is performed in a course of adding a differential absolute value of each sampling point and a regular data point is extracted according to a result of the error judgment.

For example, sampling points where an error between data value on a straight line connecting between data of two sampling points (between differential total data or between regular sample data and differential total data) and a differential total data value at the same sampling point as a data value on the straight line is up to a desired value are sequentially detected as sample points. Moreover, regular sample data is adopted for a sampling point immediately after the detected sample point.

This will be described specifically in accordance with an example of FIG. 6 as follows. First, differential total data is found for respective sampling points with the first sample data S1 as a reference. Then, when a sampling point where the above-described error is up to a desired value, which is'a sampling point where a time interval is the longest within a predetermined clock range from the first sample data S1, is found, it is a second sampling point in the case of this example. Thus, the sample data S2 of this point is detected as an amplitude data of a sample point and, at the same time, the regular sample data S3 at the next sampling point is adopted as sample data of a regular data point.

Next, differential total data is found for each sampling point thereafter with this regular sample data S3 as a reference. Then, when a sampling point where the above-described error is up to a desired value, which is a sampling point where a time interval is the longest within a predetermined clock range from the sample data S3, is found, it is a sixth sampling point in the case of this example. Thus, the sample data S6 of this point is detected as amplitude data of a sample point and, at the same time, the regular sample data S7 at the next sampling point is adopted as sample data of a regular data point. The same processing is repeated thereafter.

If such processing is performed, a sampling point immediately after a certain sample point is necessarily a regular data point, and the next sample point necessarily exists after the regular data point. That is, differential total data of a sample point adopted as compression data and regular sample data alternately appear. Thus, timing data represents a time interval between a certain regular data point and a sample point thereafter.

In the second embodiment, discrete differential total data at each sample point obtained by such processing, regular sample data at each regular data point, timing data representing a time interval between the regular data points and polarity data of a differential value at each sampling data are obtained as compression data, which are transferred to a transmission medium or recorded in a recording medium.

On the other hand, a decompression system according to the second embodiment for decompressing the compression data that is generated as described above is substantially the same as the decompression system described in the first embodiment. That is, an amplitude data value at a sampling point that can exist between each sample point adopted as compression data is found based on differential total data at each sample point included in inputted compression data, timing data and polarity data of a differential value at each sampling point.

Then, interpolation calculation for interpolating the above-described found amplitude data at each sampling point and the regular sample data included in the compression data is sequentially performed, whereby interpolation data for interpolating respective data is generated. Moreover, the generated interpolation data is D/A converted to an analog signal and outputted according to necessity.

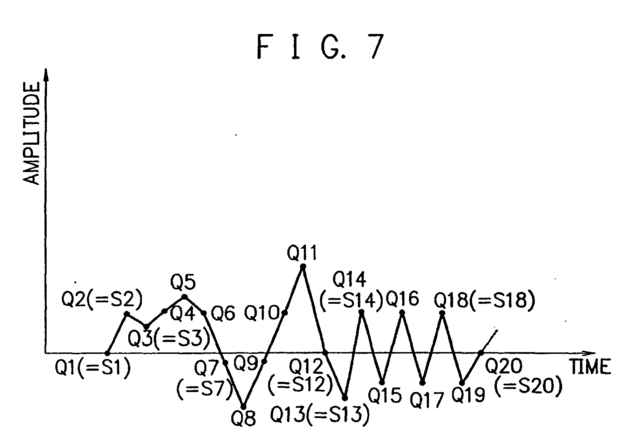

FIG. 7 shows reproduced data in the case in which compression data generated in accordance with the compression system according to the second embodiment is decompressed. In an example of FIG. 7, reference symbols Q1 to Q20 also denote decompressed data values at each sampling point. Among them, Q1, Q3, Q7, Q12, Q14 and Q20 are regular sample data value at regular data points. In addition, five points of D2, D6, D11, D13 and D19 are detected as sample points as a result of the processing shown in FIG. 6 here.

In this case, since other sampling point does not exist between the first regular sample data S1 included in the compressed data and the differential total data D2 at the first sample point, the regular sample data S1 and the differential total data D2 are directly adopted as amplitude data values Q1 and Q2 of decompression data. In addition, since other sampling point does not exist between the differential total data D2 at the first sample point and the next regular sample data S3 as well, the regular sample data S3 is directly adopted as the amplitude data Q3 of the decompression data.

Next, since three sampling points exist between this regular sample data S3 and the differential total data D6 at the next sample point, amplitude data values Q4 to Q6 at these three sampling points are found based on regular sample data S3 and the differential total data D6 included in the compression data, timing data (3CLK) between them and polarity data (+, +, -) of a differential value at each sample point.

That is, first, an average differential data value per one clock (= (D6 -S3)/3) is calculated from a difference between the regular sample data S3 and the differential total data D6 at the sample point and the timing data value between them (4CLK). Then, a value found by multiplying this average differential data value by polarities (+, +, -) of a differential value at each sampling point is sequentially added to the regular sample data S3, whereby the amplitude data values Q4 to Q6 at three sampling points are found. Then, the regular sample data S7 at the next sampling point is directly adopted as the amplitude data Q7 of decompression data.

Moreover, four sampling points exist between this regular sample data S7 to the differential total data D11 of the next sample point. Thus, amplitude data values Q8 to Q11 at these four sampling points are found based on the regular sample data S7 and the differential total data D11 included in the compression data, the timing data between them (4CLK) and polarity data (0, +, +, +) of differential values at each sampling point.

That is, first, an average differential data value per one clock (= (D11 - S7)/4) is calculated from a difference between the regular sample data S7 and the differential total data D11 at the sample point and the timing data value between them (4CLK). Then, a value found by multiplying this average differential data value by polarities (-, +, +, +) of a differential value at each sampling point is sequentially added to the regular sample data S7, whereby the amplitude data values Q8 to Q11 at four sampling points are found. Then, the regular sample data S12 at the next sampling point is directly adopted as the amplitude data Q12 of decompression data.

Thereafter, the same processing as above is performed, whereby the amplitude data values Q13 to Q20 at each sampling point are found. Then, the amplitude data values Q1 to Q20 at each sampling point found as described above are interpolated, whereby interpolation data of a waveform as shown in FIG. 7 is obtained. Moreover, the D/A conversion processing is applied to the generated interpolation data to convert it into an analog signal and output it.

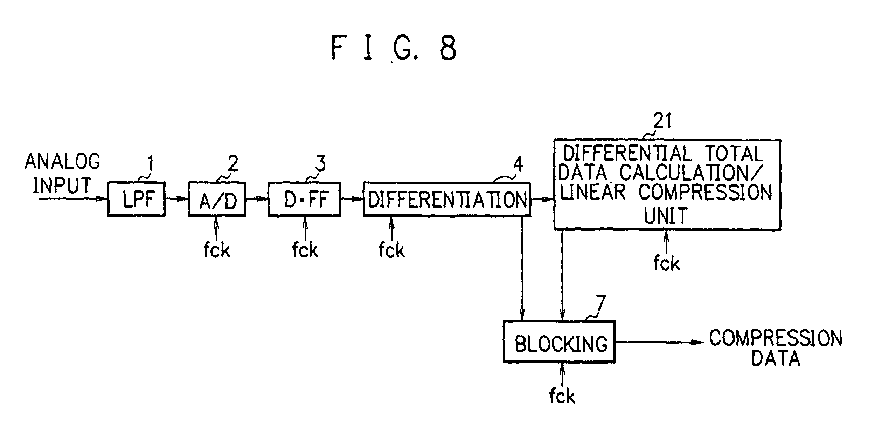

FIG. 8 is a block diagram showing an example of a functional configuration of a compression device according to the second embodiment for realizing the above-described compression system. Note that, in FIG. 8, since parts having the reference symbols identical with those shown in FIG. 4 have the identical functions, descriptions of the parts will be omitted here.

As shown in FIG. 8, the compression device according to the second embodiment is provided with a differential total data calculation/linear compression unit 21 instead of the differential total data calculation unit 5 and the linear compression unit 6 provided in the compression device according to the first embodiment shown in FIG. 4.

The differential total data calculation/linear compression unit 21 finds an absolute value of the differential value calculated for each sampling point by the differential unit 4 and sequentially adds respective absolute values for each sampling point. At this point, the error judgment as shown in FIG. 2 is performed in the course of the addition, and sampling points where an error between a data value on a straight line connecting data of two sampling point and a differential total data value at the same sampling point as the data value on the straight line is up to a desired value are sequentially detected as sample points. Moreover, processing for adopting regular sample data is applied to a sampling point immediately after the detected sample point.

By such processing, the differential total data calculation/linear compression unit 21 generates the data D1 to D20 of a waveform indicated by an alternate long and short dash line of FIG. 6. Consequently, differential total data at each sample point forming the compression data, regular sample data at a regular data point, timing data representing a time interval between them and data representing a polarity of a differential value at each sampling point are found.

A structure of a decompression device corresponding to the above-described compression device is the same as that shown in FIG. 5.

The compression device and the decompression device according to the second embodiment constituted as described above are also constituted by a computer system provided with, for example, a CPU or an MPU, an ROM and an RAM. All or a part of functions of them (e.g., the differential unit 4, the differential total data calculation/linear compression unit 21 and the blocking unit 7 of the compression device, the linear decompression unit 11 and the interpolation processing unit 13 of the decompression device, and the like) are realized by a program stored in the ROM or the RAM operating. In addition, it is also possible to constitute the compression device and the decompression device according to this embodiment constituted as described above in a hardware-like manner by combining a logic circuit.

As described above in detail, in the second embodiment, a quality of data reproduced by decompression can be improved while realizing a high compression ratio as in the first embodiment. In addition, in the case in which a signal with a high frequency is compressed, the number of sample points to be detected can be reduced as much as possible and a high compression ratio can be realized. In addition, since data can be directly compressed or decompressed on a time axis, processing does not become complicated and a structure can also be simplified. Further, a real time operation of compression and decompression can be realized.

Moreover, in the second embodiment, a sampling point where, even when linear interpolation is applied to differential total data, an error between the interpolated data and the original data is not larger than a desired value is detected as a sample point, and the regular sample data is necessarily adopted at sampling point immediately after it (a point where the difference between the interpolate data and the original data is larger than the desired value). Consequently, an accumulated error can be reduced and a quality of data reproduced by decompression can be further improved compared with the case in which differential absolute values are added unconditionally up to a predetermined threshold value as in the first embodiment.

Further, in the above-described second embodiment, differential total data at each sample point, timing data representing a time interval between sample points, regular sample data at each regular data point and polarity data of a differential value at each sampling point are found as compression data, and average differential value data per one clock is also found on a decompression side from the differential total data and the timing data at each sample point included in this compression data. However, this average differential data may be found on a compression side to make it a part of the compression data.

In this way, respective data amount can be compressed compared with the case in which differential total data itself is held as compression data, and a compression ratio as a whole can be further increased. In addition, on the decompression side, calculation for finding average differential value data also becomes unnecessary, and calculation load can be reduced to shorten a reproduction time.

In addition, in the above-described second embodiment, the next sampling point of a sample point that is detected by error judgment performed for each range of a predetermined clock is extracted as a regular data point. However, the present invention is not limited to this example. For example, processing is performed without setting a limit of within a predetermined range to a time interval between two data that is selected in detecting discrete sample points. Then, sampling points immediately before sampling points where an error exceeds a desired value may be sequentially detected as sample points and, at the same time, the sampling points where an error exceeds a desired value may be extracted as regular data point.

In such a case, the number of sample points can be further reduced and a compression ratio can be further increased while preventing an accumulated error from becoming large by the insertion of regular sample data.

In addition, in the above-described second embodiment, after certain regular sample data is found, subsequent differential total data are calculated with the regular sample data as a starting point (e.g., the differential total data D4 to D6 are found with the regular sample data S3 as a starting point, and after finding the regular sample data S7 again, the differential total data D8 to D11 are found with this as a starting point). However, the present invention is not limited to such an algorithm.

For example, first, differential absolute values at all sampling points are added to simply find differential total data. Then, the above-described error judgment may be applied to the differential total data found in this way to sequentially finding sample points and regular sample data. In this case, returning to regular sample data as shown in FIG. 6 becomes completely unnecessary, and an algorithm on a compression side can be simplified to reduce processing load. In addition, average differential value data is used as a part of compression data instead of differential total data at each sample point, whereby a high compression ratio can be maintained.

In addition, although the example for linearly interpolating the digital data Q1 to Q20 in the interpolation processing unit 13 was also described in the above-described second embodiment, an interpolation calculation is not limited to this example. For example, curve interpolation processing using a predetermined sampling function may be performed. In addition, the interpolation processing described in Japanese Patent Application No. 11-173245 or the like, which the applicant filed earlier, may be performed. In this case, since a waveform extremely close to analog can be obtained by interpolation itself, it is possible to make the D/A conversion unit 14 and the LPF 15 at later stages of the interpolation processing unit 13 unnecessary.

### (Third embodiment)

Next, a third embodiment of the present invention will be described.

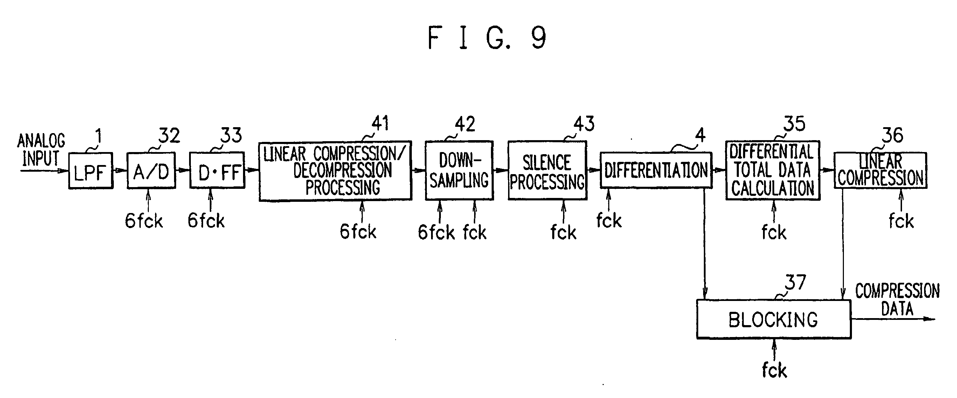

FIG. 9 is a block diagram showing an example of a functional configuration of a compression device according to the third embodiment. Note that, in FIG. 9, since parts denoted by the reference symbols identical with those shown in FIGS. 4 and 8 have the identical functions, repeated descriptions will be omitted here.

As shown in FIG. 9, in the compression device according to the third embodiment, an A/D conversion unit 32 and a D type flip flop 33 are provided instead of the A/D conversion unit 2 and the D type flip flop 3 shown in FIGS. 5 and 8 and, at the same time, a linear compression/decompression processing unit 41 and a down-sampling unit 42 are provided.

The A/D conversion unit 32 and the D type flip flop 33 are functionally the same as the A/D conversion unit 2 and the D type flip flop 3 shown in FIGS. 5 and 8. However, it is different in that it operates in accordance with a clock of a frequency 6fck that is six times as high as a reference frequency. That is, in the third embodiment, data to be compressed is over-sampled by six times using the A/D conversion unit 32 and the D type flip flop 33.

The compression/decompression processing unit 41 applies linear compression in accordance with the algorithm shown in FIG. 2 to sample data itself of over-sampled each sampling point outputted from the D type flip flop 33 and, at the same time, processing of linear decompression to compression data obtained by the linear compression to reproduce the original data.

The compression data obtained in this case is constituted only by amplitude data at each sample point and timing data representing a time interval between sample points. As the sample points, sampling points where an error between each data value on a straight line connecting two sample data and each sample data value at the same sampling point as each data value on the straight line is up to a desired value, which are sampling points where a time interval is the longest within a range of a predetermined clock from sample data to be a reference, are detected.

In addition, such linear decompression processing of compression data simply interpolates amplitude data at each sample point of the compression data linearly at a time interval indicated by timing data. That is, an interpolation calculation for linearly interpolating amplitude data of consecutive sample points is sequentially performed based on inputted compression data (a set of amplitude data and timing data), whereby interpolation data for interpolating respective amplitude data is generated.

At the time of compression, it is examined, if two sample data are linearly interpolated, how large error occurs between other sample data, which exist between the two sample data, and the interpolated straight line, and points where an error does not become large even if the linear interpolation is performed are detected as sample points. Therefore, data of a waveform substantially the same as the original data before compression can be reproduced simply by linearly interpolating amplitude data of each discrete sample point obtained in this way. In addition, processing of linear compression/decompression is applied to sample data itself in this way, whereby unnecessary high frequency component to be a cause of noise can be removed.

The down-sampling unit 42 down-samples data outputted by the above-described linear compression/decompression processing unit 41 in accordance with a clock of the original reference frequency fck. In this way, in performing the linear compression/decompression processing before differential processing by the differential unit 4, the linear compression/decompression processing is applied to data over-sampled to a six times frequency and a result of the linear compression/decompression processing is down-sampled to an original frequency, whereby only an unnecessary high frequency component can be removed without breaking a waveform of the original data before compression significantly.

In the third embodiment, a silence processing unit 43 is provided in the next stage of this down-sampling unit 42. If an absolute value of each sample data outputted from the down-sampling unit 42 is smaller than a predetermined value (e.g., "4"), the silence processing unit 43 regards the sample data as silence and performs processing for replacing a data value with "0" and outputting it. Consequently, further improvement of a compression ratio is realized.

A differential total data calculation unit 35 sequentially adds differential absolute values at all sampling points without performing returning to regular sample data as shown in FIG. 6 to calculate differential total data at each sampling point. A linear compression unit 36 applies error judgment to the differential total data found in this way in accordance with the algorithm shown in FIG. 2 to sequentially find sample points and regular data points. Consequently, regular sample data at each regular data point, timing data representing a time interval between a regular data point and a sample point and average differential value data per one clock between a regular data point and a sample point can be obtained as a part of compression data.

A blocking unit 37 appropriately blocks the regular sample data, timing data and average differential value data that are generated by the linear compression unit 36 and the polarity data of the differential value at each sampling point found by the differential unit 4 and outputs the blocked data as compression data. The outputted compression data is, for example, transmitted to a transmission medium or recorded in recording medium such as a nonvolatile memory.

A structure of a decompression device corresponding to the compression device according to the third embodiment described above is the same as that shown in FIG. 5. However, contents of calculation of the linear decompression unit 11 are different from those in the first and second embodiments. That is, whereas average differential value data is calculated in the linear decompression unit 11 using differential total data included in compression data in the first and second embodiments, in the third embodiment, this average differential value data is calculated on the compression device side and outputted as compression data. Thus, this calculation is unnecessary in the linear decompression unit 11.

The compression device and the decompression device according to the third embodiment constituted as described above are also constituted by a computer system provided with, for example, a CPU or an MPU, an ROM and an RAM. All or a part of functions of them (e.g., the differential unit 4, the differential total data calculation unit 35, the linear compression unit 36, the linear compression/decompression processing unit 41 and the silence processing unit 43 of the compression device and the linear decompression unit 11 and the interpolation processing unit 13 of the decompression device, and the like) are realized by a program stored in the ROM or the RAM operating. In addition, it is also possible to constitute the compression device and the decompression device according to this embodiment constituted as described above in a hardware-like manner by combining a logic circuit.

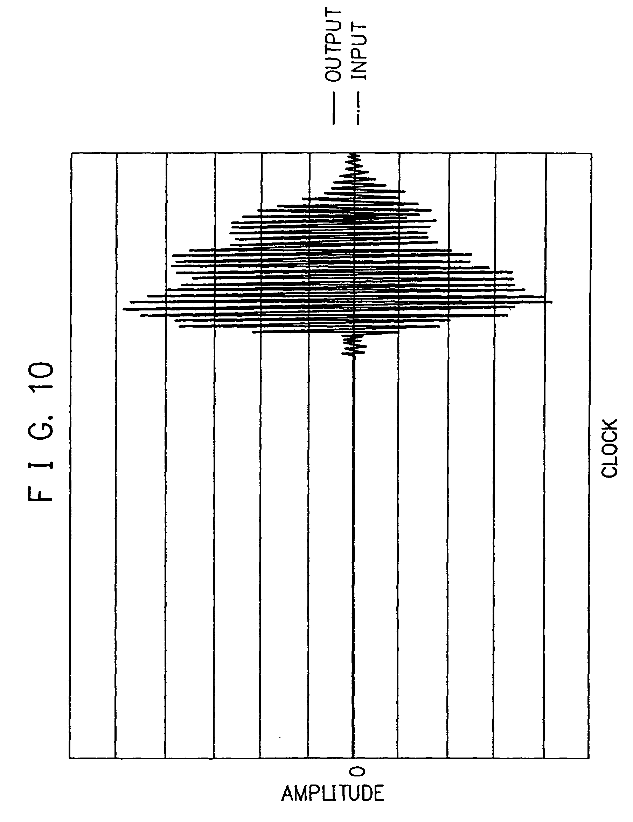

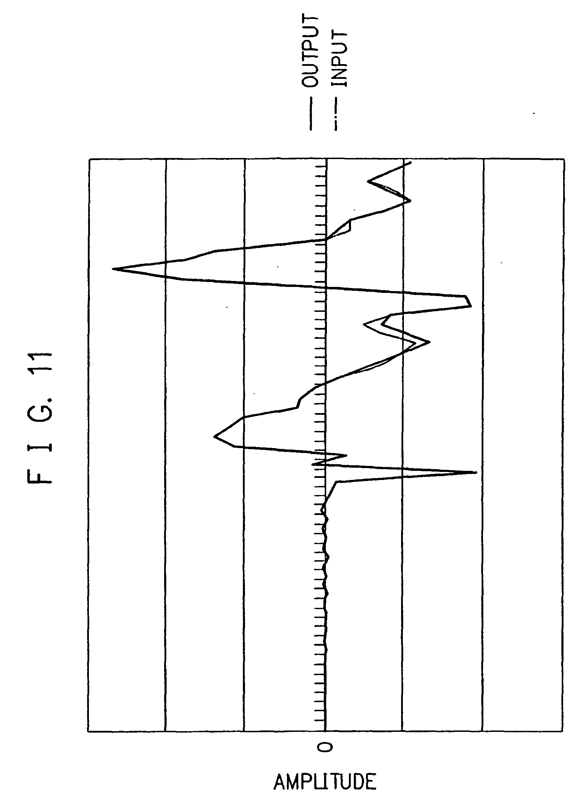

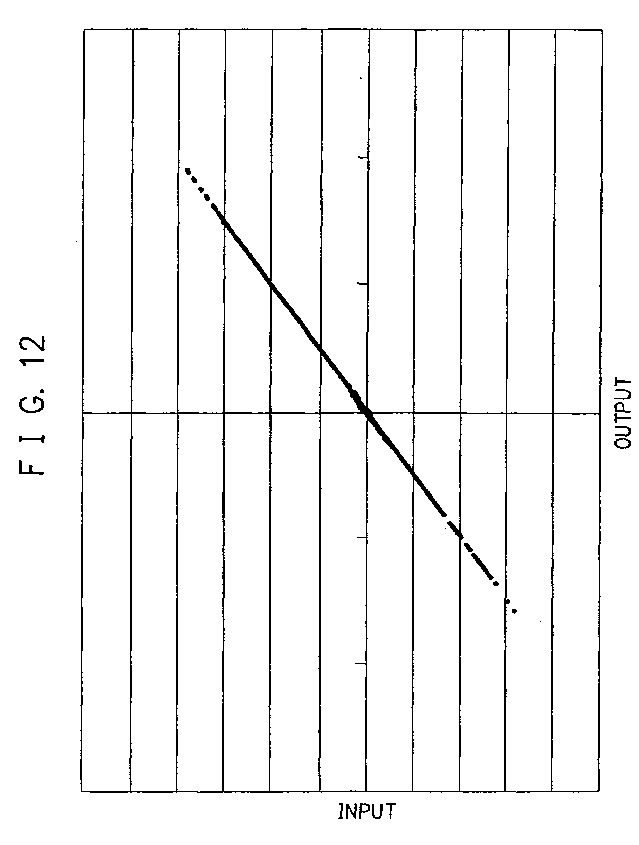

FIGS. 10 to 12 are graphs showing waveforms and characteristics of a certain analog signal (voice of a human) and a reproduced analog signal that is reproduced by applying the compression/decompression processing according to the third embodiment to the analog signal. Among the figures, FIG. 10 is a graph showing an original analog signal (input data) before compression and a waveform of a reproduced analog signal (output data) reproduced by compressing and decompressing the original analog signal. FIG. 11 is a partially enlarged graph of the waveform shown in FIG. 10. In addition, FIG. 12 is a graph showing a correlation between input data and output data.

As shown in FIG. 10, when the input data and the output data are viewed macroscopically, there is little difference between both the data (thus, waveforms of the input data and the output data substantially overlap each other on the graph). In FIG. 11, when a part of the graph is enlarged, deviation between the input and output data is only a little. In addition, as it is also seen from the correlation graph of the input and output data shown in FIG. 12, the input data and the output data substantially match. The original analog signal can be reproduced substantially faithfully if the compression/decompression system of this embodiment is used.

That is, in the third embodiment, a quality of data reproduced by decompression can be improved with a high compression ratio maintained as in the first and second embodiments. In addition, even if a signal of a high frequency is compressed, the number of sample points to be detected can be reduced as much as possible and a high compression ratio can be realized. In addition, since data can be directly compressed and decompressed on a time axis, processing does not become complicated and a structure can be simplified. Further, a real time operation of compression and decompression can be realized.

In addition, in the third embodiment, an accumulated error can be reduced and a quality of data reproduced by decompression can be further improved compared with the case in which differential absolute values are added unconditionally up to a predetermined threshold value as in the first embodiment.

Moreover, in the third embodiment, the linear compression as shown in FIG. 2 is applied to each sample data itself to decompress the compression data by linear interpolation before finding differential total data. Consequently, compression data can be found by performing the same processing as that in the first or second embodiment after removing an unnecessary high frequency component to be a cause of noise in advance, and a quality of data to be reproduced by decompression based on the compression data can be further improved.

Further, although average differential value data is found on the compression side and is made a part of the compression data in the above-described third embodiment, the average differential value data may be found on the decompression side.

In addition, in the above-described third embodiment, differential absolute values at all sampling points are simply added without performing returning to regular sample data at a regular data point. However, returning to regular sample data may be performed.

In addition, in the above-described first to third embodiments, the number of bits of timing data is set to three and a straight line is drawn within a range of six clocks from reference sample data to perform error judgment. However, the present invention is not limited to this example. For example, a predetermined range in performing the error judgment may be set to seven clocks. In addition, the number of bits of timing data may be set to four bits or more and the predetermined range in drawing a straight line from the reference sample data to perform the error judgment may be set to eight clocks or more. In this way, it is possible to further increase a compression ratio. In addition, the number of bits of timing data or the predetermined range in performing the error judgment may be set arbitrarily as a parameter.

In addition, as an allowable value of an error, for example, 64, 128, 256, 384, 512 or the like can be used. If the allowable value of an error is reduced, compression and decompression can be realized with importance attached to reproducibility of a reproduced analog signal. In addition, if the allowable value of an error is increased, compression and decompression can be realized with importance attached to a compression ratio. Further, this error allowable value may be arbitrarily set as a parameter.

In addition, the error allowable value may be a function of a data amplitude to, for example, increase the error allowable value in a part where an amplitude is large and reduce the error allowable value in a part where an amplitude is small. In the part where an amplitude is large, an error is not conspicuous even if it increases to some extent and never affects a sound quality significantly. Therefore, if the error allowable value is dynamically changed as a function of a data amplitude, it is possible to further increase a compression ratio while keeping a sound quality of reproduced data extremely good.

In addition, the error allowable value may be a function of a frequency to, for example, increase the error allowable value in a part where a frequency is high and reduce the error allowable value in a part where a frequency is low. In a part where a frequency is high in signals inputted in series as an object to be compressed, that is, a part where a sample data value changes relatively largely in an adjacent sampling point, the number of sample points to be detected increases if the error allowable value is small and a high compression ratio may not be realized. However, it is possible to further increase a compression ratio while keeping a sound quality of reproduced data extremely good as a whole by dynamically increasing the error allowable value in a part where a frequency is high.

It is needless to mention that the error allowable value maybe dynamically changed as a function of both a data amplitude and a frequency.

In addition, although a data value is over-sampled to be six times as large in the interpolation processing on the decompression side in the above-described first to third embodiments, over-sampling is not limited to six times and it is possible to perform over-sampling of any times.

In addition, the methods of compression and decompression according to the first to third embodiments described above can be realized by any of a hardware configuration, a DSP and software as described above. For example, if the methods are realized by software, the compression device and the decompression device of this embodiment are actually constituted by a CPU or an MPU, an RAM, an ROM and the like of a computer and can be realized by a program stored in the RAN or the ROM operating.

Therefore, the compression device and the decompression device can be realized by recording a program, which causes a computer to operate to carry out the functions of this embodiment, in a recording medium such as a CD-ROM and causing the computer to read the program. As a recording medium for recording the program, a floppy disk, a hard disk, a magnetic tape, an optical disk, a magneto-optical disk, a DVD, a nonvolatile memory card and the like can be used other than the CD-ROM.

In addition, the functions of the above-described embodiments are not only realized by the computer executing the supplied program. In the case in which the program cooperates with an OS (operating system), other application software or the like running on the computer to realize the functions of the above-described embodiments or in the case in which all or a part of processing of the supplied program is performed by a function extending board or a function extending unit to realize the functions of the above-described embodiments, such a program is also included in the embodiments of the present invention.

Moreover, each embodiment described above simply shows an example of embodying the present invention in implementing the same, and the technical scope of the present invention should not be interpreted in a limited manner according to the embodiments. That is, the present invention can be implemented in various forms without departing from its spirit or its major characteristics.

As described above in detail, according to the present invention, a new compression/decompression system can be provided which has a simple structure and a short processing time of compression and decompression and is capable of realizing both a high compression ratio and improvement of a quality of reproduced data.

That is, according to the present invention, sampling points where, even if data of each sampling point is reproduced from average differential value data among sample points and polarity data of a differential value in decompression processing, an error between the reproduced data and the original data is not larger than a desired value are detected as sample points, and only differential total data at discrete sample points detected in this way or average differential value data per a unit time among the sample points, timing data representing a time interval between the sample points, polarity data of a differential value of each sampling point and the like are obtained as compression data. Thus, a quality of data reproduced by decompression can be remarkably improved with a high compression ratio maintained.

In addition, according to the present invention, processing of error judgment is applied to differential total data, which is generated by differentiating each sample data and sequentially adding absolute values of the sample data, rather than applying the above-described error judgment to sample data itself at each sampling point to compress data, whereby, even if a signal of a high frequency is compressed, the number of sample points to be detected can be reduced as much as possible, and a higher compression ratio can be realized.

Moreover, according to the present invention, in compressing a signal on a time axis, the signal can be directly processed on the time axis without performing time/frequency conversion to process it on a frequency axis. In addition, in decompressing the data compressed in this way, the data can be directly processed on the time axis. In particular, on the decompression side, highly accurate decompression data substantially the same as the original data before compression can be reproduced only by performing processing for multiplying an average differential value by polarity to sequentially add it and extremely simple processing called interpolation processing.

In addition, according to another characteristic of the present invention, on the compression side, sampling points where all errors between each data value on a straight line connecting data of two sampling points and each differential total data value at the same sampling point as each data value on the straight line are up to a desired value, which are sample points where a time interval between the two sampling points is the longest within a predetermined range, are sequentially detected as sampling points of compression data. Consequently, values of respective timing data can be controlled to be within predetermined bits and a compression ratio can be improved so much for that.

In addition, according to another characteristic of the present invention, on the compression side, sampling points where an error between a data value on a straight line connecting data of two sampling points and a differential total data value at the same sampling point as the data value on the straight line is up to a desired value, which are sampling points immediately before sampling points, where the error exceeds the desired value, are sequentially detected as sample points of compression data. Consequently, the number of sample points to be detected can be reduced as much as possible with an interval between the sample points set as long as possible, and a higher compression ratio can be realized.

In addition, according to another characteristic of the present invention, average differential value data per a unit time among sample points is included as compression data, whereby respective data amount can be reduced and a compression ratio can be further increased compared with the case in which differential total data itself at each sample point is held as compression data. Further, it is unnecessary to perform processing for calculating average differential value data from differential total data and timing data at each sample point on the decompression side, and load of processing can be reduced.

In addition, according to another characteristic of the present invention, on the compression side, regular sample data at a few points at each sampling point is adopted as a part of compression data, whereby an accumulated error, which may be generated by reproducing data of each sampling point using average differential value data among sample points found from differential total data, can be eliminated by regular sample data inserted in some places, and reproducibility of a signal reproduced by decompression from the compression data can be improved.

In addition, according to another characteristic of the present invention, in a course of finding differential total data for each sampling point, regular sample data is adopted as a part of compression data at sampling points where a value of the differential total data exceeds a predetermined threshold value, whereby the value of the differential total value data included as a part of the compression data can be set not to be larger than the predetermined threshold value, and a compression ratio can be increased by reducing respective data amounts.

In addition, according to another characteristic of the present invention, regular sample data is adopted as a part of compression data at sampling points where, when linear interpolation is performed between two differential total data, an error between the interpolated data and the original data exceeds a desired value, whereby the regular sample data can be inserted in each part where an accumulated error is likely to occur to eliminate occurrence of the accumulated error, and reproducibility of a signal reproduced by decompression from the compression data can be further improved.

In addition, according to another characteristic of the present invention, on the compression side, data is compressed to find differential total data as described above after applying linear compression/decompression processing to sample data itself, whereby the data can be compressed after removing an unnecessary high frequency component to be a cause of noise in advance. Consequently, a compression ratio can be further increased, and a quality of data to be reproduced by decompression based on compression data can be further improved.

### [Industrial applicability]

The present invention is useful for providing a completely new compression/decompression system that realizes both increase in a compression ratio and improvement of a quality of reproduced data.

## Claims

1. A compression method, **characterized in that** data to be compressed is differentiated for respective sampling points and differential absolute values of the same are sequentially added to obtain differential total data for said respective sampling points, and processing is performed with respect to said differential total data in each sampling point obtained by the calculation such that sampling points where, when data between two sampling points is subject to linear interpolation, an error between the interpolated data and the original data is up to a desired value are sequentially detected as sample points of compression data.

2. A compression method, **characterized in that** data to be compressed is differentiated for respective sampling points and differential absolute values of the same are sequentially added to obtain differential total data for said respective sampling points, and processing is performed with respect to said differential total data in each sampling point obtained by the calculation such that sampling points where an error between a data value on a straight line connecting data of two sampling points and a differential total data value at the same sampling point as the data value on the straight line is up to a desired value are sequentially detected as sample points of compression data.

3. A compression method, **characterized in that** data to be compressed is differentiated for respective sampling points and differential absolute values of the same are sequentially added to obtain differential total data for said respective sampling points, and processing is performed with respect to said differential total data in each sampling point obtained by the calculation such that sampling points where all errors between each data value on a straight line connecting data of two sampling points and each differential total data value at the same sampling point as each data value on the straight line are up to a desired value, which are sample points where a time interval between said two sampling points are the longest within a predetermined range, are sequentially detected as sample points of compression data.

4. The compression method according to claim 1, **characterized in that** said compression data includes differential total data at said sample points, timing data representing a time interval between said sample points and polarity data of a differential value at each sampling point.

5. The compression method according to claim 1, **characterized in that** said compression data includes timing data representing a time interval between said sample points, data of an average differential value per a unit time among said sample points and polarity data of a differential value at each sampling point.

6. The compression method according to claim 1, **characterized in that** regular sample data at a few points in said each sampling point is adopted as a part of said compression data.

7. The compression method according to claim 1, **characterized in that**, in a course of finding said differential total data for said respective sampling point, regular sample data is adopted as a part of said compression data at sampling points where a value of said differential total data exceeds a predetermined threshold value and said differential total data is sequentially found with a value of said regular sample data as a starting point for sampling points after this regular data point.

8. The compression method according to claim 1, **characterized in that** regular sample data is adopted as a part of said compression data at sampling points where a difference between a data value at a sampling point where said regular sample data is adopted last time and a value of said differential total data found for said respective sampling points exceeds a predetermined threshold value.

9. The compression method according to claim 1, **characterized in that**, in a course of finding said differential total data for said respective sampling points, regular sample data is adopted as a part of said compression data at sampling points where, when data between two sampling points is subject to linear interpolation, an error between the interpolated data and the original data exceeds a predetermined value.

10. The compression method according to claim 9, **characterized in that** said differential total data is sequentially found with a value of said regular sample data as a starting point for sampling points after said sampling points where the error exceeds the predetermined value.

11. The compression method according to claim 6, **characterized in that** said compression data includes said regular sample data, differential total data at said sample points, timing data representing a time interval between said sample points or between said sample points and regular data points where said regular sample data is adopted and polarity data of a differential value at each sampling point.

12. The compression method according to claim 6, **characterized in that** said compression data includes said regular sample data, timing data representing a time interval between said sample points or between said sample points and a regular data point where said regular sample data is adopted, average differential value data per a unit time among said sample points and polarity data of a differential value at each sampling point.

13. The compression method according to claim 3, **characterized in that** regular sample data is adopted as a part of said compression data at the next sampling point of said sample points.

14. A compression method, **characterized in that** data to be compressed is differentiated for respective sampling points and differential absolute values of the same are sequentially added to obtain differential total data for said respective sampling points, and processing is performed with respect to said differential total data in each sampling point obtained by the calculation such that sampling points where an error between a data value on a straight line connecting data of two sampling points and a differential total data value at the same sampling point of the data value on the straight line is up to a desired value, which are sampling points immediately before sampling points where said error exceeds said desired value, are sequentially detected as sample points of compression data.

15. The compression method according to claim 14, **characterized in that** regular sample data is adopted as a part of said compression data at sampling points where said error exceeds said desired value.

16. A compression method, **characterized in that** data to be compressed is differentiated for respective sampling points and differential absolute values of the same are sequentially added to obtain differential total data for said respective sampling points and, at the same time, in a course of finding said differential total data for said respective sampling points, regular sample data is adopted as a part of compression data at sampling points where a value of said differential total data exceeds a predetermined threshold value, and sampling points where an error between a data value on a straight line connecting said regular sample data and said differential total data or two differential total data and a differential total data value at the same sampling point as the data value on the straight line is up to a desired value, are sequentially detected as sample points of said compression data.

17. A compression method, **characterized in that** data to be compressed is differentiated for respective sampling points and differential absolute values of the same are sequentially added to obtain differential total data for said respective sampling points and, at the same time, in a course of finding said differential total data for said respective sampling points, regular sample data is adopted as a part of compression data at sampling points where, when data between two sample points is subject to linear interpolation, an error between the interpolated data and the original data exceeds a desired value, and sampling points where an error between a data value on a straight line connecting said regular sample data and said differential total data or two differential total data and a differential total data value at the same sampling point as the data value on the straight line is up to a desired value. are sequentially detected as sample points of said compression data.

18. A compression method, **characterized in that** sampling points where, when data between two sampling points included in data to be compressed is subject to linear interpolation, an error between the interpolated data and the original data is up to a desired point are sequentially detected as sample points, a set of amplitude data of each sample point and timing data representing a time interval of each sample point is obtained as linear compression data and, at the same time, decompression data is obtained by finding interpolation data for linearly interpolating amplitude data having a time interval indicated by said timing data using said amplitude data of each sample point and said timing data between them included in said linear compression data, and the processing according to claim 1 is applied to said decompression data.

19. A compression device, **characterized in that** the compression device comprises:
differentiating means for differentiating data to be compressed for respective sampling points;
differential total data calculating means for finding differential total data for said respective sampling points by sequentially adding an absolute value of differential data found by said differentiating means; and
linear compression means for applying processing of sequentially detecting sampling points, where, when data between two sampling points is subject to linear interpolation, an error between the interpolated data and the original data is up to a desired value, as sample points of compression data to said differential total data at each sampling point found by said differential total data calculating means.

20. The compression device according to claim 19, **characterized in that** said linear compression means applies processing for sequentially detecting sampling points, where, when all errors between each data value on a straight line connecting data of two sampling points and each differential total data value at the same sampling points as each data value on the straight line are up to a desired value, which are sampling points where a time interval between said two sampling points are the longest within a predetermined range, as sampling points of compression data to said differential total data at said each sampling points.

21. The compression device according to claim 19, **characterized in that**, in a course of finding said differential total data for said respective sampling points, said differential total data calculating means adopts regular sample data instead of said differential total data at sampling points where a value of said differential total data exceeds a predetermined threshold value and finds said differential total data with a value of said regular sample data as a starting point for sampling points after this regular data point.

22. The compression device according to claim 21, **characterized in that** said regular sample data is adopted as a part of said compression data.

23. The compression device according to claim 19, **characterized in that** said regular sample data is adopted as a part of said compression data at sampling points where a difference between a data value of sampling points where regular sample data is adopted last time and a value of said differential total data found for said respective sampling points exceeds a predetermined threshold value.

24. The compression device according to claim 19, **characterized in that** said linear compression means adopts regular sample data as a part of said compression data at sampling points where, when data between said two sampling points is subject to linear interpolation, an error between the interpolated data and the original data exceeds a desired value.

25. The compression device according to claim 19, **characterized in that** said differential total data calculating means sequentially finds said differential total data with a value of said regular sample data as a starting point for sampling points after sampling points where said error exceeds a desired value.

26. The compression device according to claim 20, **characterized in that** regular sample data is adopted as a part of said compression data at the next sampling points of said sample points.

27. The compression device according to claim 21, **characterized in that** said compression data includes said regular sample data, differential total data at said sample points, timing data representing a time interval between said sample points or between said sample points and regular data points where said regular sample data is adopted, and polarity data of a differential value at each sampling point.

28. The compression device according to claim 21, **characterized in that** said compression data includes said regular sample data, timing data representing a time interval between said sample points or between said sample points and regular data points where said regular sample data is adopted, average differential value data per a unit time among said sample points and polarity data of a differential value at each sampling points.

29. A compression device, **characterized in that** the compression device comprises:
differentiating means for differentiating data to be compressed for respective sampling points;
differential total data calculating means for finding differential total data for said respective sampling points by sequentially adding an absolute value of differential data found by said differentiating means; and
linear compression means for performing processing of sequentially detecting sampling points where an error between a data value on a straight line connecting data of two sampling points and a differential total data value at the same sampling points as the data value on the straight line is up to a desired value, which are sampling points immediately before sampling points where said error exceeds said desired value, as sample points of compression data.

30. The compression device according to claim 29, **characterized in that** regular sample data is adopted as a part of said compression data at sampling points where said error exceeds said desired value.

31. The compression device according to claim 19, **characterized in that** the compression device further comprises linear compression/decompression means for sequentially detecting sampling points where, when data between two sampling points included in data to be compressed is subject to linear interpolation, an error between the interpolated data and the original data is up to a desired value as sample points, obtaining a set of amplitude data of each sample point and timing data representing a time interval of each sample point as linear compression data and, at the same time, obtaining decompression data by finding interpolation data for linearly interpolating amplitude data having a time interval indicated by said timing data using said amplitude data of each sample point and said timing data between them included in said linear compression data, and said decompression data found by said linear compression/decompression means is supplied to said differentiating means.

32. A decompression method, **characterized in that** the decompression method comprises:
inputting compression data including differential total data at sample points where, when two differential total data is subject to linear interpolation, an error between the interpolated data and the original data is up to a desired value among differential total data at each sampling point found by sequentially adding differential absolute values calculated for respective sampling points for data to be compressed, timing data representing a time interval between said sample points and polarity data of a differential value at said each sampling point;
finding amplitude data at said each sampling point based on differential total data at said sample points included in said compression data, said timing data and polarity data of a differential value at said each sampling point; and
obtaining decompression data by performing interpolation calculation for interpolating said amplitude data found at said each sampling point.

33. A decompression method, **characterized in that** the decompression method comprises:
inputting compression data including differential total data at sample points where, when data between two sample points is subject to linear interpolation, an error between the interpolated data and the original data is up to a desired value among differential total data at each sampling point found by sequentially adding differential absolute values calculated for respective sampling points for data to be compressed, regular sample data adopted at a few points in said each sampling point, timing data representing a time interval between said sample points or between said sample points and regular data points where said regular sample data is adopted and polarity data of a differential value at said each sampling point;
finding amplitude data at said each sampling point based on differential total data at said sample points included in said compression data, said timing data and polarity data of a differential value at said each sampling point; and
obtaining decompression data by performing interpolation calculation for interpolating said amplitude data found at said each sampling point and said regular sample data.

34. The decompression method according to claim 32, **characterized in that** said amplitude data found at said each sampling point is found by finding average differential value data per a unit time from a difference between said timing data representing a time interval between two sampling points and data values at said two sampling points and sequentially adding a value found by multiplying said average differential value data by polarity data of a differential value at said each sampling point to an immediately preceding amplitude data value.

35. A decompression method, **characterized in that** the decompression method comprises:
inputting compression data including timing data representing a time interval between sample points where, when two differential total data is subject to linear interpolation, an error between the interpolated data and the original data is up to a desired value with respect to differential total data at each sampling point found by sequentially adding differential absolute values calculated for respective sampling points for data to be compressed, average differential value data per a unit time between said sample points and polarity data of a differential value at said each sampling point;
finding amplitude data at said each sampling point based on said average differential value data included in said compression data, said timing data and polarity data of a differential value at said each sampling point; and
obtaining decompression data by performing interpolation calculation for said interpolating amplitude data found at said each sampling point.

36. A decompression method, **characterized in that** the decompression method comprises:
inputting compression data including average differential value data per a unit time between sample points where, when two differential total data is subject to linear interpolation, the interpolated data and the original data is up to a desired value with respect to differential total data at each sampling point found by sequentially adding differential absolute values calculated for respective sampling points for data to be compressed, regular sample data adopted at a few points in said each sampling point, timing data representing a time interval between said sample points or between said sample points and regular data points where said regular sample data is adopted and polarity data of a differential value at said each sampling point;
finding amplitude data at said each sampling point based on said average differential value data included in said compression data, said timing data and polarity data of a differential value at said each sampling point; and
obtaining decompression data by performing interpolation calculation for interpolating said amplitude data found at said each sampling point and said regular sample data.

37. The decompression method according to claim 35, **characterized in that** said amplitude data at said each sampling point is found by sequentially adding a value found by multiplying said average differential value data by polarity data of a differential value at said each sampling data to an immediately preceding amplitude data value.

38. A decompression device for decompressing compression data including differential total data at sample points where, when two differential total data is subject to linear interpolation, an error between the interpolated data and the original data is up to a desired value among differential total data at each sampling point found by sequentially adding differential absolute values calculated for respective sampling points for data to be compressed, timing data representing a time interval between said sample points and polarity data of a differential value at said each sampling point, **characterized in that** the decompression device comprises:
amplitude data calculating means for finding amplitude data at said each sampling point based on differential total data at said sample points included in said compression data, said timing data and polarity data of a differential value at said each sampling point; and
interpolation processing means for obtaining decompression data by performing interpolation calculation for interpolating said amplitude data at said each sampling point found by said amplitude data calculating means.

39. A decompression device for decompressing compression data including differential total data at sample points where, when data between two sample points is subject to linear interpolation, an error between the interpolated data and the original data is up to a desired value among differential total data at each sampling point found by sequentially adding differential absolute values calculated for respective sampling points for data to be compressed, regular sample data adopted at a few points in said each sampling point, timing data representing a time interval between said sample points or between said sample points and regular data points where said regular sample data is adopted and polarity data of a differential value at said each sampling point, **characterized in that** the decompression device comprises:
amplitude data calculating means for finding amplitude data at said each sampling point based on differential total data at said sample points included in said compression data, said timing data and polarity data of a differential value at said each sampling point; and
interpolation processing means for obtaining decompression data by performing interpolation calculation for interpolating said amplitude data found at said each sampling point found by said amplitude data calculating means and said regular sample data.

40. The decompression device according to claim 38, **characterized in that** said amplitude data calculating means finds said amplitude data found at said each sampling point by finding average differential value data per a unit time from a difference between said timing data representing a time interval between two sampling points and data values at said two sampling points and sequentially adding a value found by multiplying said average differential value data by polarity data of a differential value at said each sampling point to an immediately preceding amplitude data value.

41. A decompression device for decompressing compression data including timing data representing a time interval between sample points where, when two differential total data is subject to linear interpolation, an error between the interpolated data and the original data is up to a desired value with respect to differential total data at each sampling point found by sequentially adding differential absolute values calculated for respective sampling points for data to be compressed, average differential value data per a unit time between said sample points and polarity data of a differential value at said each sampling point, **characterized in that** the decompression device comprises:
amplitude data calculating means for finding amplitude data at said each sampling point based on said average differential value data included in said compression data, said timing data and polarity data of a differential value at said each sampling point; and
interpolation processing means for obtaining decompression data by performing interpolation calculation for said interpolating amplitude data at said each sampling point found by said amplitude data calculating means.

42. A decompression device for decompressing compression data including average differential value data per a unit time between sample points where, when two differential total data is subject to linear interpolation, the interpolated data and the original data is up to a desired value with respect to differential total data at each sampling point found by sequentially adding differential absolute values calculated for respective sampling points for data to be compressed, regular sample data adopted at a few points in said each sampling point, timing data representing a time interval between said sample points or between said sample points and regular data points where said regular sample data is adopted and polarity data of a differential value at said each sampling point, **characterized in that** the decompression device comprises:
amplitude data calculating means for finding amplitude data at said each sampling point based on said average differential value data included in said compression data, said timing data and polarity data of a differential value at said each sampling point; and
interpolation processing means for obtaining decompression data by performing interpolation calculation for interpolating said amplitude data at said each sampling point found by said amplitude data calculating means and said regular sample data.

43. The decompression device according to claim 41, **characterized in that** said amplitude data calculating means finds said amplitude data at said each sampling point by sequentially adding a value found by multiplying said average differential value data by polarity data of a differential value at said each sampling point to an immediately preceding amplitude data value.

44. A compression/decompression system, **characterized in that**, on a compression side, the compression/decompression system differentiates data to be compressed for respective sampling points and sequentially adds differential absolute values of the same, thereby finding differential total data for said respective sampling points, and performs processing with respect to said differential total data in each sampling point obtained by the calculation such that sampling points where, when data between two sample points is subject to linear interpolation, an error between the interpolated data and the original data is up to a desired value are sequentially detected as sample points of compression data, thereby obtaining compression data including differential total data at each sample point, timing data representing a time interval between said sample points and a polarity data of a differential value at each sampling point, and on a decompression side, the compression/decompression system finds amplitude data at said each sampling point based on differential total data at said sample points included in said compression data, said timing data and polarity data of a differential value at said each sampling point and obtains decompression data by performing interpolation calculation for interpolating said amplitude data found at said each sampling point.

45. A compression/decompression system, **characterized in that**, on a compression side, the compression/decompression system differentiates data to be compressed for respective sampling points and sequentially adds differential absolute values of the same, thereby finding differential total data for said respective sampling points, and performs processing with respect to said differential total data in each sampling point obtained by the calculation such that sampling points where, when data between two sample points is subject to linear interpolation, an error between the interpolated data and the original data is up to a desired value are sequentially detected as sample points of compression data and, at the same time, regular sample data at a few point in said each sampling point is adopted, thereby obtaining compression data including said regular sample data, differential total data at each sample point, timing data representing a time interval between said sample points or between said sample points and regular data points where said regular sample data is adopted and polarity data of a differential value at each sampling point, and on a decompression side, the compression/decompression system finds amplitude data at said each sampling point based on differential total data at said sample points included in said compression data, said timing data and polarity data of a differential value at said each sampling point and obtains decompression data by performing interpolation calculation for interpolating said amplitude data found at said each sampling point and said regular sampling data.

46. A compression/decompression system, **characterized in that**, on a compression side, the compression/decompression system differentiates data to be compressed for respective sampling points and sequentially adds differential absolute values of the same, thereby finding differential total data for said respective sampling points, and performs processing with respect to said differential total data in each sampling point obtained by the calculation such that sampling points where, when data between two sample points is subject to linear interpolation, an error between the interpolated data and the original data is up to a desired value are sequentially detected as sample points of compression data, thereby obtaining compression data including timing data representing a time interval between said sample points, average differential data per a unit time between said sample points and polarity data of a differential value at each sampling point, and on a decompression side, the compression/decompression system finds amplitude data at said each sampling point based on said average differential value data included in said compression data, said timing data and polarity data of a differential value at said each sampling point and obtains decompression data by performing interpolation calculation for interpolating said amplitude data found at said each sampling point.

47. A compression/decompression system, **characterized in that**, on a compression side, the compression/decompression system differentiates data to be compressed for respective sampling points and sequentially adds differential absolute values of the same, thereby finding differential total data for said respective sampling points, and performs processing with respect to said differential total data in each sampling point obtained by the calculation such that sampling points where, when data between two sample points is subject to linear interpolation, an error between the interpolated data and the original data is up to a desired value are sequentially detected as sample points of compression data and, at the same time, regular sample data at a few point in said each sampling point is adopted, thereby obtaining compression data including said regular sample data, timing data representing a time interval between said sample points or between said sample points and regular data points where said regular sample data is adopted, average differential value data per a unit time between said sample points and polarity data of a differential value at each sampling point, and on a decompression side, the compression/decompression system finds amplitude data at said each sampling point based on said average differential value data included in said compression data, said timing data and polarity data of a differential value at said each sampling point and obtains decompression data by performing interpolation calculation for interpolating said amplitude data found at said each sampling point and said regular sample data.

48. A computer readable recording medium, **characterized in that** a program for causing a computer to execute processing procedures of the compression method according to claim 1 is recorded therein.

49. A computer readable recording medium, **characterized in that** a program for causing a computer to execute processing procedures of the decompression method according to claim 32 is recorded therein.

50. A computer readable recording medium, **characterized in that** a program for causing a computer to function as each means according to claim 19 is recorded therein.

51. A computer readable recording medium, **characterized in that** a program for causing a computer to function as each means according to claim 38 is recorded therein.

52. A computer readable recording medium, **characterized in that** a program for causing a computer to realize the functions of the compression/decompression system according to claim 44 is recorded therein.

53. The compression method according to claim 1, **characterized in that** an allowable value of said error is dynamically changed as a function of at least one of an amplitude and a frequency of said data to be compressed.
